# EUROPEAN PATENT SPECIFICATION

(11) **EP 2 224 587 B1**
(45) Date of publication and mention of the grant of the patent: **14.11.2012**
(21) Application number: 10001617.9
(22) Date of filing: 17.02.2010
(51) Int. Cl.: H02P 6/18, G01R 19/00, G05F 3/18, G05F 3/24, H02M 1/36

(54) **Induced voltage detector circuit, motor drive semiconductor device having the same, motor and air conditioner**
Schaltkreis zur Erfassung induzierter Spannung, Motorantriebshalbleiterbauelement mit diesem Schaltkreis, Motor und Klimaanlage
Circuit de détecteur de tension induite, dispositif semi-conducteur de commande de moteur en disposant, moteur et climatiseur

(30) Priority: 25.02.2009 JP 2009041643
(43) Date of publication of application: 01.09.2010
(73) Proprietor: Hitachi, Ltd., Chiyoda-ku Tokyo 100-8280 (JP)
(72) Inventor: Sakurai, Kenji, Chiyoda-ku Tokyo 100-8220 (JP); Hasegawa, Hiroyuki, Chiyoda-ku Tokyo 100-8220 (JP); Utsumi, Tomoyuki, Chiyoda-ku Tokyo 100-8220 (JP); Maeda, Daisuke, Chiyoda-ku Tokyo 100-8220 (JP)
(74) Representative: Beetz & Partner

(56) References cited:
- DE-A1- 4 029 057
- JP-A- 3 183 976
- JP-A- 7 327 399
- JP-A- 10 234 198
- JP-A- 11 023 618
- JP-A- 61 086 820
- JP-A- 61 157 293
- US-A1- 2005 162 105

## Description

The present invention relates to an induced voltage detector circuit for detecting an induced voltage generated in a motor, a motor drive semiconductor device including the induced voltage detector circuit, a motor and an air conditioner.

In recent years, inverter-controlled three-phase permanent magnet motors are widely adopted as the motors for electric home appliances and industries.
Low cost is desired for these motors. Some of these motors adopt a sensor-less method without using a position sensor as one method of reducing a cost. Even when an inverter is not driven, the motor may enter a free run state because of inertia or the influences of an external force such as wind. In order to drive a motor in the free run state adopting the sensor-less method, it is necessary to acquire information such as a position of each magnetic pole of a rotor, a revolution direction and a revolution velocity of the motor in the free run state. As a method of acquiring this information, a method has been adopted for detecting an induced voltage generated in a coil of the motor.

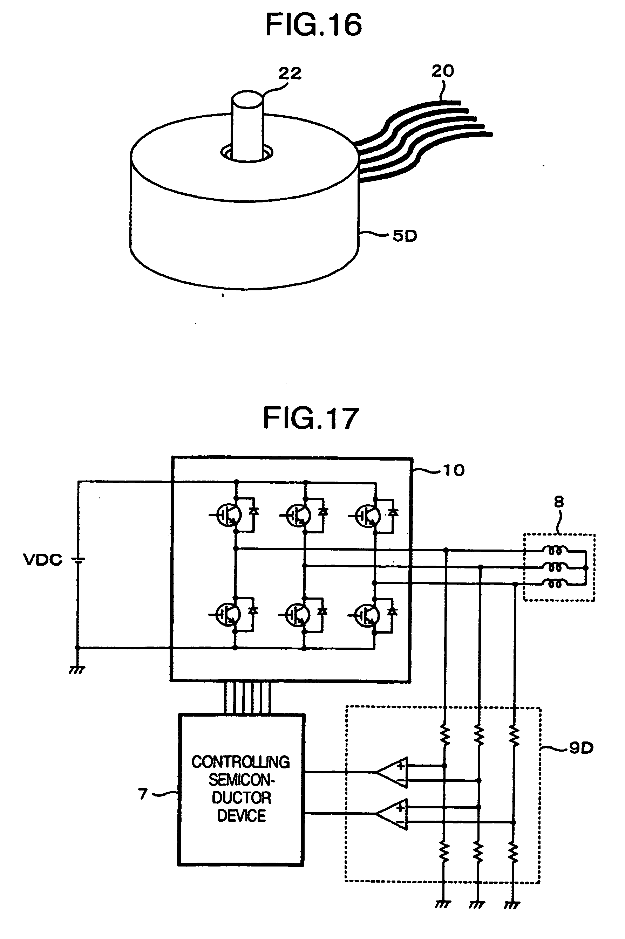

With reference to Fig. 17, an example of an induced voltage detector circuit will be described.

Referring to Fig. 17, a DC power source voltage VDC is input to a motor drive inverter 10, and three output terminals of the motor drive inverter 10 are connected to a coil 8 of a three-phase motor. An induced voltage detector circuit 9D is constituted of six resistors and two comparators. The resistors divide a voltage of each phase of the coil 8 of the three-phase motor. Voltages of two phases divided by the resistors are input to the comparator which outputs an H or L signal representative of a positive or negative induced voltage across the lines (across two phases). An output signal of each comparator is input to a control semiconductor device 7. These techniques are described in JP-A-2005-137106.

The document US 2005/162105 discloses a vibration linear actuating device with a driver including a zero-cross detector having an output to be fed back to an output controller in order to enable the powering of a coil in one way.

The document JP 07-327399 discloses a sensor for synchronizing a stepping motor by sensing a voltage at a voltage dividing point of a voltage-divider circuit. The document DE 40 29 057 A1 discloses a source for constant voltage using an N-channel field-effect transistor (N-FET), wherein the constant voltage is generated at the source-terminal of the N-FET.

The document JP 03-108976 discloses a magnetic sensor including two magneto-resistance effect elements and a field-effect transistor, wherein one output terminal is arranged between the two magneto-resistance effect elements in order to avoid a deterioration of the sensivity with increasing temperature.

### SUMMARY OF THE INVENTION

According to the above-described conventional techniques, since current flows through the resistors serially connected between the output terminals of the inverter and GND, there arises a problem that a power is consumed. Further, since the comparators are used, there arises a problem that a circuit scale becomes large and a cost becomes high.

There is another method different from the conventional techniques illustrated in Fig. 17. This method does not use comparators, but a voltage of each phase at an output terminal of an inverter is divided by resistors and input to an A/D port of a control semiconductor device. With this method, although comparators are not necessary, it is necessary to use a plurality of A/D ports of the control semiconductor device. There arises therefore a problem that an expensive control semiconductor device having many A/D ports is required and a cost becomes high.

The present invention has been made in view of the above-described points, and aims to provide an induced voltage detector circuit capable of reducing a consumption power, lowering a cost, detecting an induced voltage without A/D ports, detecting an induced voltage even at a low revolution velocity and realizing high noise immunity, a motor drive semiconductor device including the induced voltage detector circuit, a motor and an air conditioner.

In order to achieve the above-described objects, the invention proposes the subject-matter of claim 1.

The dependent claims recite advantageous embodiments of the invention.

According to the present invention, it is possible for the induced voltage detector circuit to reduce a consumption power, lower a cost, detect an induced voltage without A/D ports, detect an induced voltage even at a low revolution velocity and realize high noise resistance.

### BRIEF DESCRIPTION OF THE DRAWINGS

Fig. 1 is a circuit diagram illustrating a first embodiment of the present invention.
Fig. 2 is a diagram illustrating waveforms of voltages (induced voltages) at output terminals of an inverter using as a reference a voltage at a neutral point of a motor.
Fig. 3 is a diagram illustrating waveforms of voltages at output terminals of the inverter and output signals of induced voltage detector circuits.
Fig. 4 is a diagram illustrating the internal structure of the induced voltage detector circuit of the first embodiment.
Fig. 5 is a diagram illustrating the characteristics of a first operation example of the induced voltage detector circuit.
Fig. 6 is a diagram illustrating the characteristics of a second operation example of the induced voltage detector circuit.
Fig. 7 is a diagram illustrating the characteristics of a third operation example of the induced voltage detector circuit.
Fig. 8 is a diagram illustrating the characteristics of a fourth operation example of the induced voltage detector circuit.
Fig. 9 is a diagram illustrating the characteristics of a fifth operation example of the induced voltage detector circuit.
Fig. 10 is a diagram illustrating the specific structure of the induced voltage detector circuit of the first embodiment.
Fig. 11 is a diagram illustrating the specific structure of an induced voltage detector circuit according to a second embodiment of the present invention.
Fig. 12 is a circuit diagram illustrating a third embodiment of the present invention.
Fig. 13 is a circuit diagram illustrating a fourth embodiment of the present invention.
Fig. 14 is a broken perspective view illustrating a first example of the structure of a motor according to a fifth embodiment of the present invention.
Fig. 15 is a broken perspective view illustrating a second example of the structure of the motor according to the fifth embodiment of the present invention.
Fig. 16 is a broken perspective view illustrating a third example of the structure of a motor according to a fifth embodiment of the present invention.
Fig. 17 is a diagram illustrating the circuit structure of an example of an induced voltage detector circuit.

### DESCRIPTION OF THE EMBODIMENTS

The details of the present invention will be described with reference to the accompanying drawings.

### [First Embodiment]

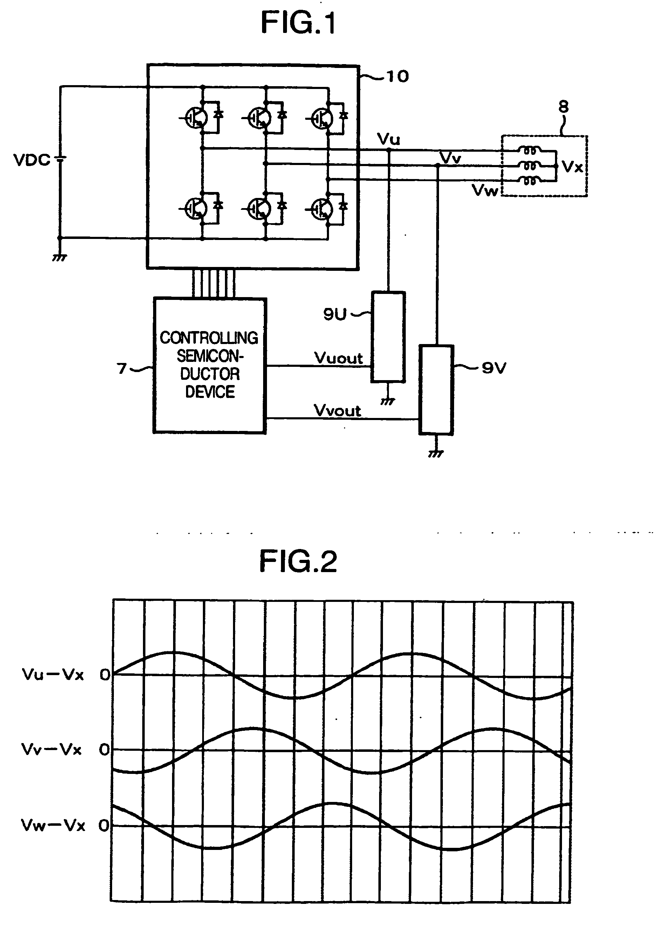

Fig. 1 is a circuit diagram illustrating the first embodiment of the present invention.

As illustrated in Fig. 1, a DC power source voltage VDC is input to a motor drive inverter 10. For example, the DC power source voltage VDC is about 140 V to 600 V. The motor drive inverter 10 includes six switching elements for inverter-driving a three-phase motor, and six free-wheeling diodes antiparallel connected to the respective switching elements. Three output terminals of the motor drive inverter 10 are connected to a coil 8 of the three-phase motor. A U-phase induced voltage detector circuit 9U is connected to a U-phase output terminal of the inverter, and a U-phase output terminal voltage Vu of the inverter is used as an input voltage to the U-phase induced voltage detector circuit 9U. A V-phase induced voltage detector circuit 9V is connected to a V-phase output terminal of the inverter, and a V-phase output terminal voltage Vv of the inverter is used as an input voltage to the U-phase induced voltage detector circuit 9V.
An output signal Vuout of the U-phase induced voltage detector circuit and an output signal Vvout of the V-phase induced voltage detector circuit are input to a control semiconductor device 7. The control semiconductor device 7 outputs six control signals for controlling on/off of the six switching elements of the motor drive inverter 10.

In Fig. 1, the output terminals of the motor drive inverter 10 are directly connected to the coil 8, and these connection points are directly connected to the induced voltage detector circuits. However, these direct connections are not necessarily required, but circuit elements or the like may be interposed so long as information on the induced voltage value is input to the induced voltage detector circuits.

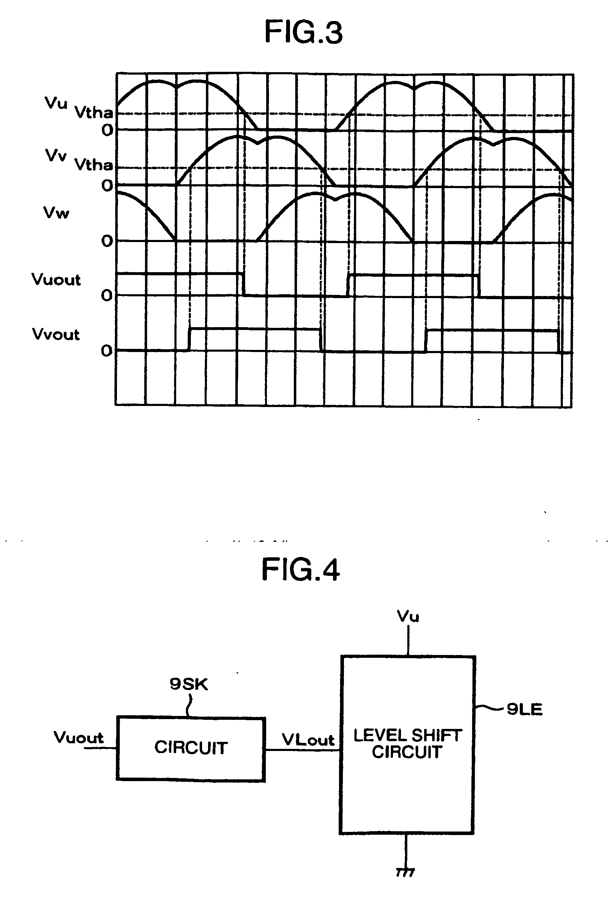

Next, description will be made on waveforms of induced voltages with reference to Fig. 2. Fig. 2 illustrates waveforms of U-, V- and W-phase voltages at the output terminals of the inverter by using as a reference a voltage Vx at a neutral point of the motor. As the induced voltages having the waveforms illustrated in Fig. 2 are generated on each phase of the coil, waveforms of voltages Vu, Vv and Vw at the output terminals of the inverter using GND as a reference are illustrated in Fig. 3. This is because the voltage is clamped to a GND level by the free-wheeling diode of the lower arm at the phase having the lowest voltage among the voltages Vu, Vv and Vw at the output terminals of the inverter. The voltage value clamped is precisely - VF (VF: a forward voltage drop of a free-wheeling diode). This value is set to 0 V in Fig. 3 because VF has a small value of several V or lower.

The induced voltage detector circuit outputs H when the voltage at the output terminal of the inverter of the corresponding phase is a reference level Vtha or higher, and outputs L when the voltage is smaller than the reference level Vtha.

The control semiconductor device 7 illustrated in Fig. 1 acquires information on a magnetic pole position, a revolution direction, a revolution velocity and the like of a rotor in accordance with the output waveforms of the induced voltage detector circuits. Although two induced voltage detector circuits are used in Fig. 1, a single induced voltage detector may be used, for example, in the case wherein a revolution direction is not required to be detected.

In Fig. 2, ideal sine waves are illustrated as the waveforms of U-, V- and W-phase voltages at output terminals of the inverter by using as a reference the voltage Vx at the neutral point of the motor. Actual motors may have sine waves with distortion or trapezoidal waves. Also in these cases, waveforms of the voltages Vu, Vv and Vw of respective phases at the output terminals of the inverter using GND as a reference are analogous to those illustrated in Fig. 3. Therefore, similar to the ideal sine waves, it is possible to acquire information on the magnetic pole position, revolution direction, revolution velocity and the like of the motor in the free run state, in accordance with the output signals of the induced voltage detector circuits representative of the H/L signals converted from the waveforms at the output terminals.

Next, with reference to Fig. 4, description will be made on the internal structure of the induced voltage detector circuit. Fig. 4 illustrates the induced voltage detector circuit of the U-phase (one phase). The induced voltage detector circuit is constituted of a level shift circuit 9LE and a circuit 9SK with a preset threshold voltage. The level shift circuit 9LE shifts a level of an input U-phase voltage Vu at the output terminal of the inverter, and outputs the shifted voltage. The circuit 9SK with a preset threshold voltage compares an output signal VLout from the level shift circuit 9LE with a preset threshold level, and outputs an H or L signal as a signal Vuout.

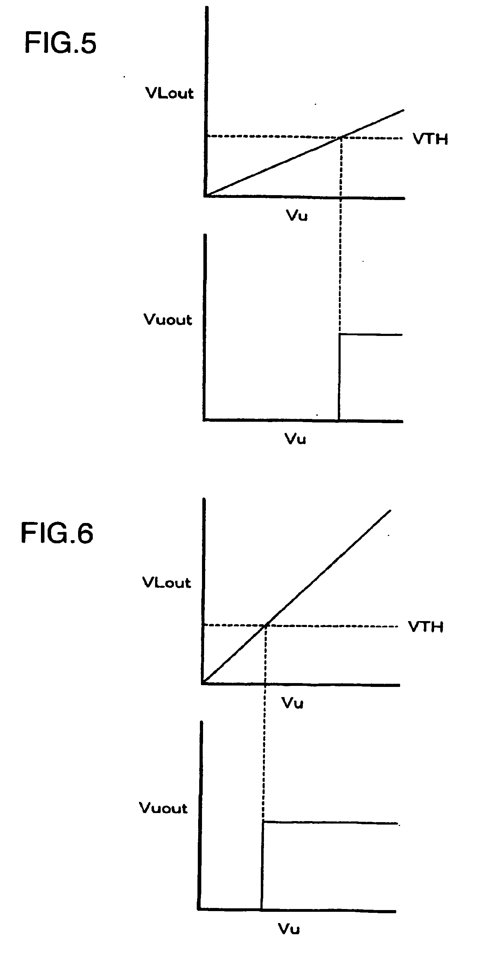

Fig. 5 is a diagram illustrating the characteristics of an operation example of the induced voltage detector circuit. VTH in Fig. 5 represents a threshold voltage of the circuit 9SK having a preset threshold voltage. The level shift circuit 9LE shifts the level of an input voltage Vu at the output terminal and outputs the shifted voltage. The circuit 9SK with a preset threshold voltage compares the level-shifted signal Vuout with the threshold voltage VTH, and outputs an H/L signal as the signal Vuout.

If an induced voltage is sufficiently high, it is possible to detect the induced voltage without doubt. However, if an induced voltage is low, for example, because of a low revolution velocity of the motor in the free run state, or, for example, if a voltage obtained by level-shifting the peak value of the induced voltage waveform illustrated in Fig. 3 is lower than VTH, then it is not possible to detect an induced voltage, and a signal Vuout of the induced voltage detector circuit is maintained at a fixed L.

An example of a countermeasure is illustrated in Fig. 6. In this example, an output voltage VLout of the level shift circuit 9LE is raised so that it becomes possible to detect even a low induced voltage. However, in this case, if an induced voltage generated in the free run state is high or if the motor is inverter-driven at a high DC power source voltage VDC, a high voltage is applied to the circuit 9SK with a preset threshold voltage. The circuit 9SK with a preset threshold voltage is therefore required to have a high breakdown voltage so as not to be broken by an applied high voltage.

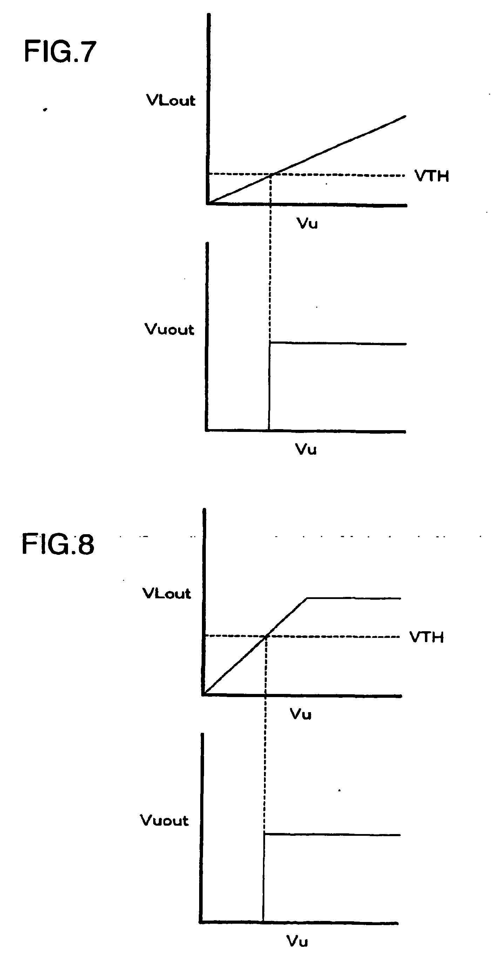

Another example of the countermeasure is illustrated in Fig. 7. In this example, the threshold voltage VTH is lowered so that it becomes possible to detect even a low induced voltage. However, in this case, the circuit 9SK with a preset threshold value may operate erroneously, for example, if noises are superposed at VLout of 0 V, VLout is raised by noises.

A countermeasure for the cases illustrated in Figs 6 and 7 is illustrated in Fig. 8. In this example, the output voltage VLout of the level shift circuit depends upon Vu in a range of Vu equal to or lower than a predetermined voltage, and becomes nearly constant in a range of Vu higher than the predetermined voltage. The circuit 9SK with a preset threshold voltage is not required to have a high breakdown voltage, and feasibility of an erroneous operation due to noises is eliminated because the threshold voltage VTH is not required to be lowered. Without making the circuit 9SK with a preset threshold voltage have a high breakdown voltage, it becomes possible to stably detect an induced voltage even if an induced voltage is low because the revolution velocity of the motor in the free run state is low.

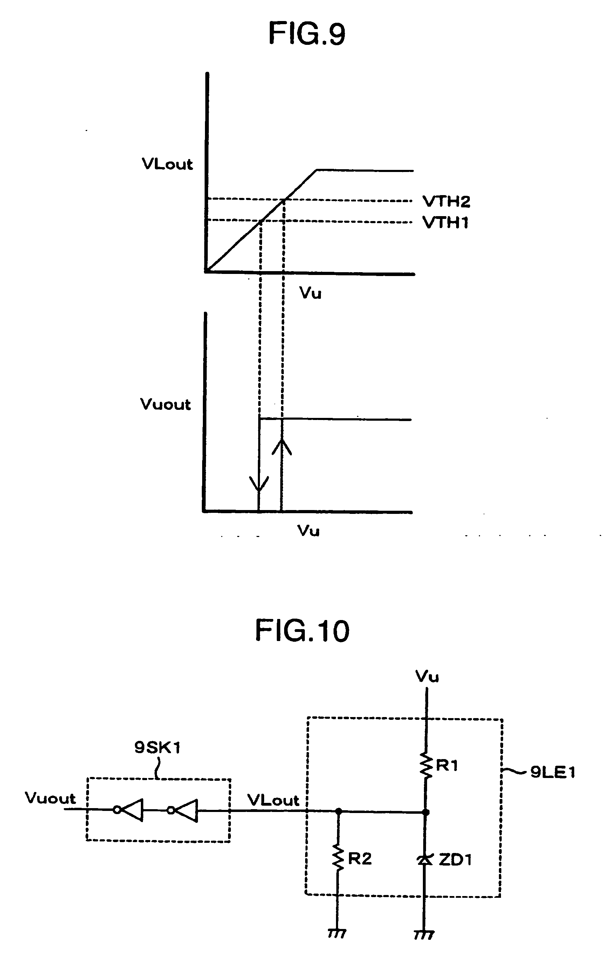

An improved version of the countermeasure illustrated in Fig. 8 is illustrated in Fig. 9. In this example, the circuit 9SK with a preset threshold voltage has hysteresis. H/L signals of Vuout are switched at a lower threshold voltage VTH1 while Vu lowers, and at a higher threshold voltage VTH2 while Vu rises. It is therefore possible to obtain a stable signal Vuout without chattering when VLout is near at the threshold value.

Fig. 10 illustrates an example of the specific structure of the induced voltage detector circuit. A level shift circuit 9LE1 is constituted of resistors R1 and R2 and a Zener diode ZD1. A Zener voltage of the Zener diode ZD1 is set higher than the threshold voltage VTH. By using the Zener diode in the level shift circuit 9LE1, the output voltage VLout of the level shift circuit becomes dependent upon Vu in a range of Vu equal to or lower than a predetermined voltage, and becomes nearly constant in a range of Vu higher than the predetermined voltage, as illustrated in Figs. 8 and 9. In Fig. 10, a circuit 9SK1 having a preset threshold voltage is constituted of NOT circuits. If the circuit 9SK1 having a preset threshold voltage is made to have hysteresis like that illustrated in Fig. 9, a Schmitt circuit is used as the circuit 9SK1 having a preset threshold voltage.

### [Second Embodiment]

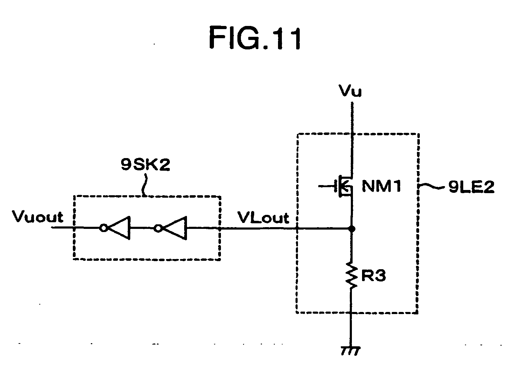

An induced voltage detector circuit of the second embodiment has the structure illustrated in Fig. 11. A level shift circuit 9LE2 is constituted of an NMOS NM1 and a resistor R3. While an induced voltage is detected, NMOS NM1 turns on. By using NMOS in the level shift circuit, the output voltage VLout of the level shift circuit becomes dependent upon Vu in a range of Vu equal to or lower than a predetermined voltage, and becomes nearly constant in a range of Vu higher than the predetermined voltage because of the saturated current characteristics of NMOS, as illustrated in Figs. 8 and 9. While an induced voltage is not detected, NMOS is turned off so that it is possible to make a consumption power of the level shift circuit null. In Fig. 11, a circuit 9SK2 having a preset threshold voltage is constituted of NOT circuits. If the circuit 9SK2 having a preset threshold voltage is made to have hysteresis like that illustrated in Fig. 9, a Schmitt circuit is used as the circuit having a preset threshold voltage.

In the level shift circuit illustrated in Fig. 11, since NMOS is used, the output voltage VLout of the level shift circuit becomes dependent upon Vu in a range of Vu equal to or lower than a predetermined voltage, and becomes nearly constant in a range of Vu higher than the predetermined voltage, as illustrated in Figs. 8 and 9. Instead of NMOS, a circuit element having constant current (saturated current) characteristics or a constant current circuit may also be used to make the output voltage VLout of the level shift circuit become dependent upon Vu in a range of Vu equal to or lower than a predetermined voltage, and become nearly constant in a range of Vu higher than the predetermined voltage, as illustrated in Figs. 8 and 9.

The induced voltage detector circuit is used for detecting an induced voltage of a motor when the motor enters the free run state upon inverter non-operation. Since the induced voltage detector circuit is not necessary to detect an induced voltage during inverter operation, it becomes effective to turn off NMOS and make a consumption power of the level shift circuit null.

If NMOS is not turned off during inverter operation, there is a consumption power of the level shift circuit while the switching element of the upper arm of the inverter turns on, and there is no consumption power while the switching element of the lower arm turns on. As a method of making a consumption power null, a method of turning off NMOS during inverter operation and only while the upper arm is on is also effective, in addition to the method of turning off NMOS during inverter operation.

### [Third Embodiment]

In the third embodiment, a motor drive semiconductor device is equipped with an induced voltage detector circuit.

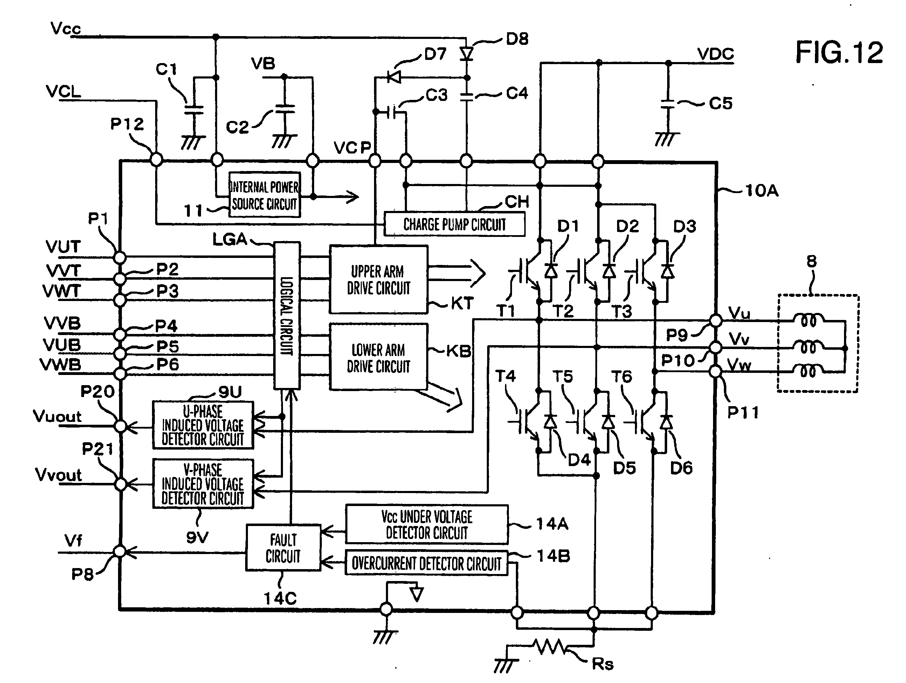

The third embodiment will be described with reference to Fig. 12. In Fig. 12, T1 to T6 represent six switching elements for driving a three-phase motor. In this embodiment, although a power semiconductor switching element IGBTs are used, the switching elements may be a power MOSFETs or power bipolar transistors. In Fig. 12, D1 to D6 represent free-wheeling diodes antiparallel connected to corresponding IGBTs.

In Fig. 12, P9 represents a U-phase output terminal, P10 represents a V-phase output terminal, and P11 represents a W-phase output terminal. These output terminals are connected to a coil 8 of a motor.

In Fig. 12, VUT represents a U-phase upper arm control signal which is input from a U-phase upper arm control signal input terminal P1, and transmitted to a logical circuit LGA, an upper arm drive circuit KT, and to a U-phase upper arm IGBT T1. In Fig. 12, VVT represents a V-phase upper arm control signal which is input from a V-phase upper arm control signal input terminal P2, and transmitted to the logical circuit LGA, upper arm drive circuit KT, and to a V-phase upper arm IGBT T2. In Fig. 12, VWT represents a W-phase upper arm control signal which is input from a W-phase upper arm control signal input terminal P3, and transmitted to the logical circuit LGA, upper arm drive circuit KT, and to a W-phase upper arm IGBT T3. In Fig. 12, VUB represents a U-phase lower arm control signal which is input from a U-phase lower arm control signal input terminal P4, and transmitted to the logical circuit LGA, a lower arm drive circuit KB, and to a U-phase lower arm IGBT T4. In Fig. 12, VVB represents a V-phase lower arm control signal which is input from a V-phase lower arm control signal input terminal P5, and transmitted to the logical circuit LGA, lower arm drive circuit KB, and to an V-phase lower arm IGBT T5. In Fig. 12, VWB represents a W-phase lower arm control signal which is input from a W-phase lower arm control signal input terminal P6, and transmitted to the logical circuit LGA, lower arm drive circuit KB, and to a W-phase lower arm IGBT T6.

In Fig. 12, a charge pump circuit CH is a circuit for generating an upper arm IGBT drive power source voltage VCP. Diodes D7 and D8 and capacitors C3 and C4 are external components connected to the charge pump circuit. The diodes D7 and D8 for the charge pump circuit may be built in the motor drive semiconductor device 10A. A clock signal VCL for driving the charge pump circuit CH is input to the charge pump circuit CH from a clock signal input terminal P12.

An internal power source circuit 11 generates an internal power source voltage VB from a drive circuit power source voltage Vcc. A Vcc under voltage detector circuit 14A monitors the drive circuit power source voltage Vcc, and when the drive circuit power source voltage Vcc becomes equal to or lower than a threshold voltage, outputs a Vcc under voltage detection signal to a fault circuit 14C. An overcurrent detector circuit 14B outputs an overcurrent detection signal to the fault circuit 14C when a voltage across a shunt resistor Rs takes a predetermined level or higher. Upon reception of the Vcc under voltage detection signal from the Vcc under voltage detector circuit 14A or the overcurrent detection signal from the overcurrent detector circuit 14B, the fault circuit 14C outputs an off signal to the logical circuit LGA, and outputs a fault signal Vf via a fault signal output terminal P8. Upon reception of an off command signal from the fault circuit 14C, the logical circuit LGA outputs a signal turning off all IGBTs irrespective of H/L of the arm control signals VUT, VVT, VWT, VUB, VVB and VWB.

In Fig. 12, C1, C2 and C5 represent power source stabilizing capacitors.

In Fig. 12, a U-phase induced voltage detector circuit 9U is connected to a U-phase output terminal P9. The logical circuit LGA supplies the U-phase induced voltage detector circuit with a signal for turning off a circuit element of the level shift circuit of the induced voltage detector circuit during inverter operation. An output signal Vuout of the U-phase induced voltage detector circuit 9U is output via a U-phase induced voltage signal output terminal P20.

In Fig. 12, a V-phase induced voltage detector circuit 9V is connected to a V-phase output terminal P10. The logical circuit LGA supplies the V-phase induced voltage detector circuit with a signal for turning off a circuit element of the level shift circuit of the induced voltage detector circuit during inverter operation. An output signal Vvout of the V-phase induced voltage detector circuit 9V is output via a V-phase induced voltage signal output terminal P21.

If the motor drive semiconductor device 10A is made of one semiconductor chip, high voltage elements and low voltage elements are mixed in one semiconductor chip. An isolation for each element in the semiconductor chip may be realized by DI, SOI, PN junction or the like.

### [Fourth Embodiment]

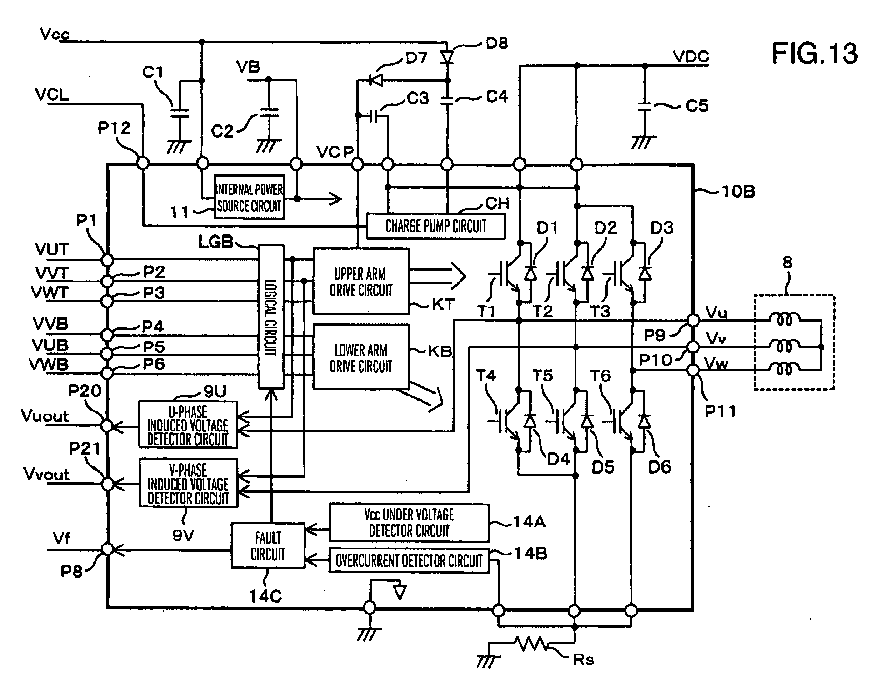

This embodiment illustrates another example of the motor drive semiconductor device equipped with the induced voltage detector circuit, and will be described with reference to Fig. 13.

In Fig. 13, a U-phase induced voltage detector circuit 9U equipped in a motor driver semiconductor device 10B is connected to a U-phase output terminal P9. The logical circuit LGB inputs a U-phase upper arm control signal to the U-phase induced voltage detector circuit to turn off a circuit element of the level shift circuit in the induced voltage detector circuit while the U-phase upper arm is turned on. An output signal Vuout of the U-phase induced voltage detector circuit 9U is output via a U-phase induced voltage signal output terminal P20.

In Fig. 13, a V-phase induced voltage detector circuit 9V equipped in the motor driver semiconductor device 10B is connected to a V-phase output terminal P10. The logical circuit LGB inputs a V-phase upper arm control signal to the V-phase induced voltage detector circuit to turn off a circuit element of the level shift circuit in the induced voltage detector circuit while the V-phase upper arm is turned on. An output signal Vvout of the V-phase induced voltage detector circuit 9V is output via a V-phase induced voltage signal output terminal P21.

The other structures of the embodiment are similar to those of the third embodiment, and so the description thereof is omitted.

In both the third and fourth embodiments, the motor drive semiconductor device has six control signal input terminals. JP-2008-228547 describes a motor drive semiconductor device having three control signal input terminals. An induced voltage detector circuit may be fabricated in the motor drive semiconductor device having three control signal input terminals.

### [Fifth Embodiment]

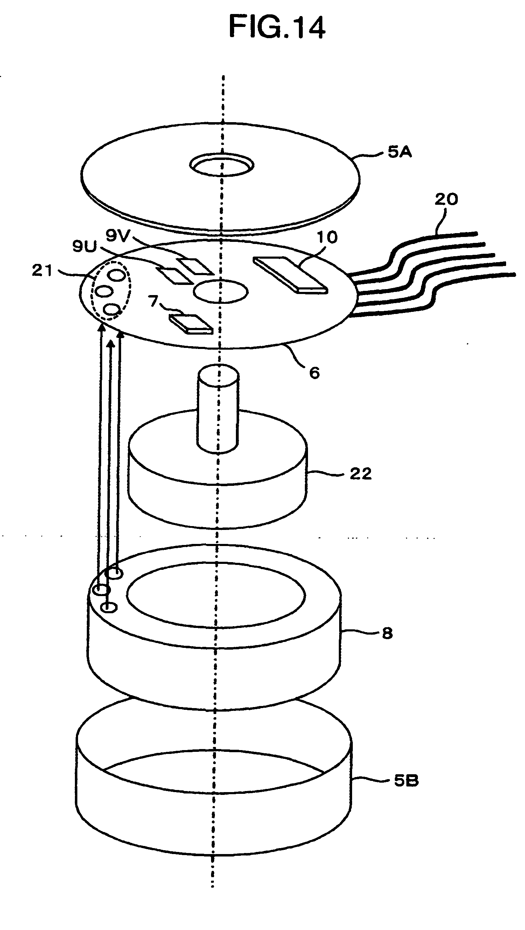

Fig. 14 illustrates an example of the structure of a motor according to the fifth embodiment. The motor illustrated in Fig. 14 is a three-phase motor. The control semiconductor device 7, U-phase induced voltage detector circuit 9U, V-phase induced voltage detector circuit 9V and motor drive inverter 10 of the first embodiment illustrated in Fig. 1 are disposed on a motor built-in printed-circuit board 6. In the motor of this embodiment, a coil 8 is embedded in a lower portion 5B of a motor housing. A permanent magnet rotor 22 is disposed in the coil with a proper gap therebetween so as not to touch the coil 8. The motor built-in printed-circuit board 6 is disposed above the permanent magnet rotor 22. Coil connection terminals 21 are disposed on the motor built-in printed-circuit board 6, and the coil 8 is connected to the terminals 21 by soldering. Motor lead wirings 20 are connected to the motor built-in printed-circuit board 6 by soldering. A top plate 5A of the motor housing like a lid is disposed above the motor built-in printed-circuit board 6. In an assemble state of the motor, the motor built-in printed-circuit board 6 is disposed in the motor housing constituted of the top plane 5A and lower portion 5B of the motor housing.

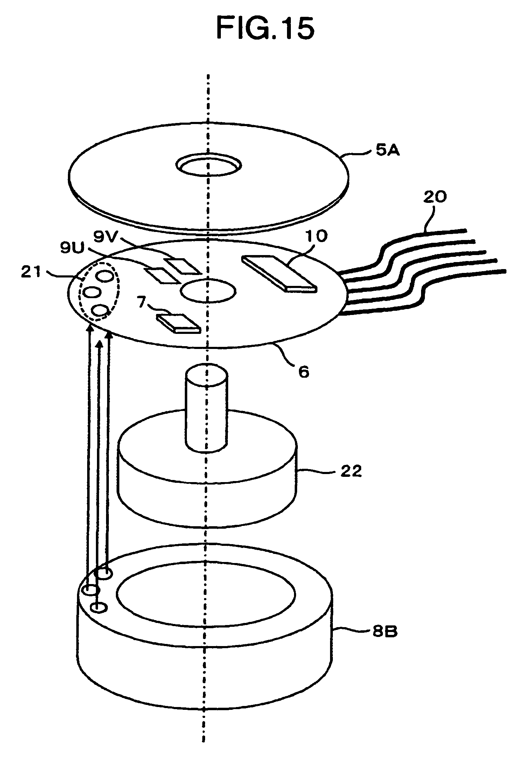

The motor may use a molded coil 8 without using the lower portion 5B of the motor housing. This structure is illustrated in Fig. 15. 8B in Fig. 15 represents a molded coil. The other structures are similar to those illustrated in Fig. 14.

The motor may have the structure that the coil 8 and motor built-in printed-circuit board 6 are molded, without using the top plate 5A and lower portion 5B of the motor housing. This structure is illustrated in Fig. 16. As different from Figs. 14 and 15, Fig. 16 illustrates an assembled state of the motor. The coil 8 and motor built-in printed-circuit board 6 are molded in a mold portion 5D. Similar to Fig. 14, a control semiconductor device 7, a U-phase induced voltage detector circuit 9U, a V-phase induced voltage detector circuit 9V and a motor drive inverter 10 are disposed on a motor built-in printed-circuit board 6.

Although all induced voltage detector circuits illustrated in Figs. 14 to 16 are disposed on the motor built-in printed-circuit board, these circuits may be built in the motor driver inverter 10.

### [Sixth Embodiment]

This embodiment applies the induced voltage detector circuit to an air conditioner. The air conditioner of the embodiment has an outdoor unit and an indoor unit. The outdoor unit includes a compressor for compressing refrigerant, an outdoor heat exchanger, a compressor drive motor for driving the compressor, and an outdoor unit fan motor for blowing air to the outdoor heat exchanger. The indoor unit includes an indoor heat exchanger and an indoor unit fan motor for blowing air to the indoor heat exchanger. Cooling or heating is performed by changing a refrigerant flow direction with a valve.

An outdoor fan of the air conditioner may enter the free run state in the forward or backward direction under the influence of wind. In order to drive the motor in the free run state, it is necessary to detect a revolution direction in the free run state. If the induced voltage detector circuit is used for detecting an induced voltage of the outdoor fan motor, it is optimum to use induced voltage detector circuits of two phases.

An indoor fan of the air conditioner is generally not influenced by an external force of wind. Therefore, a revolution direction in the free run state is only the forward direction. It is therefore unnecessary to detect the revolution direction in the free run state in order to drive the motor in the free run state. If the induced voltage detector circuit is used for detecting an induced voltage of the indoor fan motor, it is optimum to use an induced voltage detector circuit of one phase.

Description has been made on detecting an induced voltage of the motor in the free run state during inverter non-operation. It is possible to detect an induced voltage with the induced voltage detector circuit of the present invention also during inverter operation in which the switching elements of the upper and lower arms of the phase from which the induced voltage is to be detected are off and coil current of the phase is null.

The above description of preferred embodiments of the invention, the claims and the figures show multiple characterizing features of the invention in particular combinations. The skilled person will be able to find other combinations or subcombinations of these features in order to adapt the invention to his specific needs without leaving its scope as defined in the appended claims.

## Claims

1. An induced voltage detector circuit (9U, 9V) for detecting an induced voltage of a coil (8) of a motor driven by an inverter (10), the induced voltage detector circuit (9U, 9V) comprising circuit means (9LE, 9SK; 9LE1, 9SK1; 9LE2, 9SK2) configured to convert an input voltage (Vu, Vv) into an H/L signal (Vuout, Vvout) to be output, **characterized in that** ac circuit element within the induced voltage detector circuit (9U, 9V) with constant or saturated current characteristics is turned off at least when an upper arm of said inverter (10) is turned on during inverter operation.

2. The induced voltage detector circuit according to claim 1 **characterized in that** the induced voltage detector circuit comprises a level shift circuit (9LE) and a circuit (9SK) with a preset threshold voltage.

3. The induced voltage detector circuit according to claim 2 **characterized in that** a voltage value of an output signal of said level shift circuit (9LE) depends on said input voltage in a range of said input voltage equal to or lower than a predetermined voltage value, and does not depend on said input voltage but takes generally a constant value higher than a value of said threshold value, in a range of said input voltage higher than said predetermined voltage value.

4. The induced voltage detector circuit according to claim 2 **characterized in that** a Zener diode (ZD1) is used in said level shift circuit.

5. The induced voltage detector circuit according to claim 2 **characterized in that** an NMOS (NM1) is used in said level shift circuit.

6. The induced voltage detector circuit according to claim 2 **characterized in that** an element having constant current characteristics or a constant current circuit is used in said level shift circuit.

7. The induced voltage detector circuit according to claim 1 **characterized in that** an element in the induced voltage detector circuit turns off while an upper arm of a phase, from which an induced voltage is detected, is on.

8. A motor drive semiconductor device comprising switching elements (T1, T2, T3, T4, T5, T6) for inverter-driving a motor and drive circuits (KT, KB) for driving said switching elements, **characterized in that** the motor drive semiconductor device includes the induced voltage detector circuit recited in any one of claims 1 to 7.

9. A motor to be inverter-driven **characterized in that** the motor includes the induced voltage detector circuit recited in any one of claims 1 to 7.

10. An air conditioner comprising a compressor for compressing refrigerant, an outdoor heat exchanger for heat exchange with said refrigerant, and an indoor heat exchanger for heat exchange with said refrigerant, **characterized in that** the air conditioner includes the induced voltage detector circuit recited in any one of claims 1 to 7.

## Patentansprüche

1. Induzierte-Spannung-Erfassungsschaltkreis (9U, 9V) zum Erfassen einer induzierten Spannung einer Spule (8) eines Motors, der von einem Wechselrichter (10) angetrieben wird, wobei der Induzierte-Spannung-Erfassungsschaltkreis (9U, 9V) Schaltkreismittel (9LE, 9SK; 9LE1, 9SK1; 9LE2, 9SK2) umfasst, die dazu konfiguriert sind, eine Eingangsspannung (Vu, Vv) in ein auszugebendes H/L-Signal (Vuout, Vvout) umzuwandeln,
**dadurch gekennzeichnet, dass** ein Schaltkreiselement in dem Induzierte-Spannung-Erfassungsschaltkreis (9U, 9V) mit einer konstanten oder gesättigten Stromkennlinie zumindest dann abgeschaltet wird, wenn ein oberer Strang des Wechselrichters (10) während der Wechselrichterbetätigung eingeschaltet wird.

2. Induzierte-Spannung-Erfassungsschaltkreis nach Anspruch 1, **dadurch gekennzeichnet, dass** der Induzierte-Spannung-Erfassungsschaltkreis einen Pegelverschiebungsschaltkreis (9LE) und einen Schaltkreis (9SK) mit einer voreingestellten Schwellenspannung umfasst.

3. Induzierte-Spannung-Erfassungsschaltkreis nach Anspruch 2, **dadurch gekennzeichnet, dass** ein Spannungswert eines Ausgangssignals des Pegelverschiebungsschaltkreises (9LE) von der Eingangsspannung in einem Bereich der Eingangsspannung abhängt, der gleich einem oder niedriger als ein vorgegebener Spannungswert ist und nicht von der Eingangsspannung abhängt, sondern grundsätzlich einen konstanten Wert annimmt, der höher als ein Wert des Schwellenwerts in einem Bereich der Eingangsspannung ist, die höher als der vorgegebene Spannungswert ist.

4. Induzierte-Spannung-Erfassungsschaltkreis nach Anspruch 2, **dadurch gekennzeichnet, dass** eine Zenerdiode (ZD1) in dem Pegelverschiebungsschaltkreis verwendet wird.

5. Induzierte-Spannung-Erfassungsschaltkreis nach Anspruch 2, **dadurch gekennzeichnet, dass** ein NMOS (NM1) in dem Pegelverschiebungsschaltkreis verwendet wird.

6. Induzierte-Spannung-Erfassungsschaltkreis nach Anspruch 2, **dadurch gekennzeichnet, dass** ein Element mit konstanten Stromkennlinien oder ein Konstantstromschaltkreis in dem Pegelverschiebungsschaltkreis verwendet wird.

7. Induzierte-Spannung-Erfassungsschaltkreis nach Anspruch 1, **dadurch gekennzeichnet, dass** sich ein Element in dem Induzierte-Spannung-Erfassungsschaltkreis abschaltet, während ein oberer Strang einer Phase, von dem eine induzierte Spannung erfasst wird, an ist.

8. Motorantriebshalbleiterbauelement mit Schaltungselementen (T1, T2, T3, T4, T5, T6) zum Wechselrichterantreiben eines Motors und Antriebschaltkreisen (KT, KB) zum Ansteuern der Schaltungselemente, **dadurch gekennzeichnet, dass** das Motorantriebshalbleiterbauelement den in irgendeinem der Ansprüche 1 bis 7 angegebenen Induzierte-Spannung-Erfassungsschaltkreis einschließt.

9. Motor, der wechselrichterangetrieben werden soll, **dadurch gekennzeichnet, dass** der Motor den in irgendeinem der Ansprüche 1 bis 7 angegebenen Induzierte-Spannung-Erfassungsschaltkreis einschließt.

10. Klimaanlage mit einem Kompressor zum Verdichten von Kühlmittel, einem Außen-Wärmetauscher zum Wärmeaustausch mit dem Kühlmittel und einem Innen-Wärmetauscher zum Wärmeaustausch mit dem Kühlmittel, **dadurch gekennzeichnet, dass** die Klimaanlage den in irgendeinem der Ansprüche 1 bis 7 angegebenen Induzierte-Spannung-Erfassungsschaltkreis einschließt.

## Revendications

1. Circuit de détection de tension induite (9U, 9V) permettant de détecter une tension induite d'une bobine (8) d'un moteur commandé par un onduleur (10), le circuit de détection de tension induite (9U, 9V) comprenant un moyen de circuit (9LE, 9SK ; 9LE1, 9SK1 ; 9LE2, 9SK2) configuré pour convertir une tension d'entrée (Vu, Vv) en signal H/L (Vuout, Vvout) destiné à être émis, **caractérisé en ce qu'**un élément de circuit dans le circuit de détection de tension induite (9U, 9V) avec des caractéristiques de courant constant ou saturé est désactivé au moins quand un bras supérieur dudit onduleur (10) est activé durant le fonctionnement de l'onduleur.

2. Le circuit de détection de tension induite selon la revendication 1, **caractérisé en ce que** le circuit de détection de tension induite comprend un circuit de changement de niveau (9LE) et un circuit (9SK) avec une tension de seuil établie au préalable.

3. Le circuit de détection de tension induite selon la revendication 2, **caractérisé en ce qu'**une valeur de tension d'un signal de sortie dudit circuit de changement de niveau (9LE) dépend de ladite tension d'entrée dans une plage de tensions de ladite tension d'entrée égale ou inférieure à une valeur de tension déterminée au préalable et ne dépend pas de ladite tension d'entrée mais prend généralement une valeur constante supérieure à une valeur de ladite tension de seuil, dans une plage de tensions de ladite tension d'entrée supérieure à ladite valeur de tension déterminée au préalable.

4. Le circuit de détection de tension induite selon la revendication 2, **caractérisé en ce qu'**une diode Zener (ZD1) est utilisée dans ledit circuit de changement de niveau.

5. Le circuit de détection de tension induite selon la revendication 2, **caractérisé en ce qu'**un NMOS (NM1) est utilisé dans ledit circuit de changement de niveau.

6. Le circuit de détection de tension induite selon la revendication 2, **caractérisé en ce qu'**un élément ayant des caractéristiques de courant constant ou un circuit de courant constant est utilisé dans ledit circuit de changement de niveau.

7. Le circuit de détection de tension induite selon la revendication 1, **caractérisé en ce qu'**un élément dans le circuit de détection de tension induite se désactive quand un bras supérieur d'une phase, à partir de laquelle une tension induite est détectée, est activé.

8. Dispositif semi-conducteur de commande de moteur comprenant des éléments de commutation (T1, T2, T3, T4, T5, T6) permettant de commander un moteur par onduleur et des circuits de commande (KT, KB) permettant de commander lesdits éléments de commutation, **caractérisé en ce que** le dispositif semi-conducteur de commande de moteur inclut le circuit de détection de tension induite selon l'une quelconque des revendications 1 à 7.

9. Moteur destiné à être commandé par un onduleur **caractérisé en ce que** le moteur inclut le circuit de détection de tension induite selon l'une quelconque des revendications 1 à 7.

10. Climatiseur comprenant un compresseur permettant de comprimer un agent réfrigérant, un échangeur de chaleur extérieur pour l'échange de chaleur avec ledit agent réfrigérant, et un échangeur de chaleur intérieur pour l'échange de chaleur avec ledit agent réfrigérant, **caractérisé en ce que** le climatiseur inclut le circuit de détection de tension induite selon l'une quelconque des revendications 1 à 7.
